# EUROPEAN PATENT SPECIFICATION

(11) **EP 2 256 782 B1**
(45) Date of publication and mention of the grant of the patent: **29.08.2018**
(21) Application number: 09161034.5
(22) Date of filing: 25.05.2009
(51) Int. Cl.: H01J 37/32

(54) **Plasma deposition source and method for depositing thin films**
Plasmaablagerungsquelle und Verfahren zum Ablagern von Dünnfilmen
Source de dépôt de plasma et procédé pour déposer des films minces

(43) Date of publication of application: 01.12.2010
(73) Proprietor: Applied Materials, Inc., Santa Clara, CA 95054 (US)
(72) Inventor: Morrison, Neil, 63654 Buedingen (DE); Herzog, Andre, 63755 Alzenau (DE); Hein, Stefan, 63825 Blankenbach (DE); Skuk, Peter, 61130 Nidderau (DE)
(74) Representative: Zimmermann & Partner Patentanwälte mbB

(56) References cited:
- EP-A- 0 942 473
- WO-A-92/15722
- JP-A- 2001 049 440
- US-A1- 2008 096 305
- BUGNON G ET AL: "Influence of pressure and silane depletion on microcrystalline silicon material quality and solar cell performance", JOURNAL OF APPLIED PHYSICS, AMERICAN INSTITUTE OF PHYSICS, US, vol. 105, no. 6, 20 March 2009 (2009-03-20), pages 64507-64507, XP012120211, ISSN: 0021-8979, DOI: 10.1063/1.3095488

## Description

### TECHNICAL FIELD OF THE INVENTION

Embodiments of the present invention relate to a plasma enhanced chemical vapor deposition system for depositing thin films onto substrates. In particular, embodiments relate to a plasma deposition source for transferring a deposition gas into a plasma phase by means of RF (radio frequency) electrodes. Furthermore, the present invention relates to a method for depositing thin films onto a moving substrate.

### BACKGROUND OF THE INVENTION

PECVD (plasma-enhanced chemical vapor deposition) provides a powerful tool for depositing thin films onto a variety of substrates. This type of thin film deposition has many applications, e.g. in the microelectronic industry, for depositing photovoltaic layers onto flexible substrates, for modifying surfaces of substrates in general, etc. Silicon-based deposition gases are used e.g. for the fabrication of thin silicon films on substrates for manufacturing of photovoltaic cells. Deposition gases which are used to deposit silicon-based materials onto substrates typically include silane or silane-based precursor gases.

For example, document EP 0 942 473 A describes a process for forming a microcrystalline silicon series thin film by arranging a long substrate in a vacuum chamber so as to oppose an electrode provided in said vacuum chamber and while transporting said long substrate in a longitudinal direction, causing glow discharge between said electrode and said long substrate to deposit said microcrystalline silicon series thin film on said long substrate, wherein a plurality of bar-like shaped electrodes as said electrode are arranged such that they are perpendicular to a normal line of said long substrate and their intervals to said long substrate are all or partially differed.

In another example, document WO 92/15722 A describes a continuous apparatus for the glow discharge deposition of amorphous silicon alloy solar cells of p-i-n-type configuration in a plurality of interconnected, dedicated deposition chambers, a plasma bar operatively disposed between at least the plasma regions in which the layer pairs of amorphous silicon alloy material defining the major semiconductor junction of the solar cell are deposited. The plasma bar is adapted to initiate a plasma so as to prevent chemically adsorbed contaminants from deleteriously affecting the surface of the first deposited of the layer pair, thereby improving the open circuit voltage of the solar cell. In a similar manner, the plasma bar may also be provided between the layer pairs of amorphous silicon alloy material which combine to define the minor semiconductor junction of the solar cell. Finally, a plasma bar may be disposed between the oxide-based layer of a back reflector for reducing oxygen contamination of the silicon alloy material deposited thereupon.

In yet another example, document to provide a method and device for forming a plasma CVD film of high throughput capable of realizing a high film forming rate. The faces to be film-formed in substrates to be passed through substrate transferring lines are proximately confronted with the circumferential faces of plural rotary drum electrodes, the rotary drum electrodes are respectively positioned to the substrate transferring lines, a stage in which each rotary drum electrode is rotated, a stage in which, in such a manner that the circumferential face of each rotary drum electrode in the process of rotation is proximately confronted with the face to be film-formed in the substrate, the substrate is transferred along the substrate transferring line, and a stage in which reactive gas is fed to the space between each rotary drum electrode in the process of rotation and the substrate in the process of transfer, furthermore, each rotary drum electrode is applied with high frequency to generate plasma in the space between each rotary drum electrode in the process of rotation and the substrate in the process of transfer, and the substrate in the process of transfer is continuously film-formed are provided.

A behavior of these gases, when transferred from the gas phase into the plasma phase, is an issue with respect to deposition rate, uniformity of the thin films (thickness, composition) and a formation of unwanted reaction products and dust. In the case of the use of silane for the generation of photovoltaic cells, a formation of silane dust is deleterious for the thin film being deposited. A more efficient deposition of thin films onto substrates is based on an increase in the deposition rate and a reduction of the formation of dust (silane dust, etc.).

Linear PECVD sources may be used for a dynamic deposition of silicon-based materials for photovoltaic deposition applications. Additionally, costs for manufacturing photovoltaic or microelectronic components based on a deposition of thin films increase if a plasma deposition system has a reduced uptime due to unwanted dust formation. The greater the formation of dust is, the shorter time intervals between maintenance are for the entire PECVD system.

US 2008/096305 A1 discloses a method for forming a deposited film containing microcrystalline silicon on a moving substrate by plasma-enhanced CVD includes forming a deposited film containing microcrystalline silicon on a moving substrate by plasma-enhanced CVD under conditions such that when a deposited film having a thickness of 300 nm or more is formed on a substrate while the substrate is in a stationary state, an area of the microcrystalline silicon region in which an intensity of Raman scattering attributed to a crystalline substance in the deposited film is equal to or higher than three times an intensity of Raman scattering attributed to an amorphous is 50% or more of the total area based on the area of the microcrystalline silicon region and the area of a region composed of the amorphous.

BUGNON ET AL "Influence of pressure and silane depletion on microcrystalline silicon material quantity and solar cell performance", JOURNAL OF APPLIED PHYSICS, AMERICAN INSTITUTE OF PHYSICS, vol. 105, no. 6, 20 March 2009, pages 64597-64507 discloses an investigation related to hydrogenated microcrystalline silicon growth by very high frequency plasma-enhanced chemical vapor deposition in an industrial-type parallel plate reactor to study the influence of pressure and silane depletion on material quality.

In light of the above, a plasma deposition source for transferring a deposition gas into a plasma phase and for depositing, from the plasma phase, a thin film onto a substrate moving in a substrate transport direction in a vacuum chamber according to independent claim 1 is provided. Furthermore, a method for depositing a thin film onto a substrate according to independent claim 8 is provided.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Figure 1 shows a schematic view of a plasma deposition source according to embodiments described herein;
Figure 2 is a side view of the plasma deposition source shown in FIG. 1, arranged over a moving substrate to be coated;
Figure 3 is a silane depletion profile which is formed when silane-based deposition processes are carried out;
Figure 4 is a graph showing a silane depletion profile and a SiH₃ concentration profile occurring in a plasma volume, with respect to a width dimension of a RF electrode of the plasma deposition source, according to embodiments described herein;
Figure 5 is a cross-sectional view of a plasma deposition source connected to a RF generator for driving the RF electrodes according to yet further embodiments described herein;
Figure 6 is a detailed cross-sectional view of a plasma deposition source according to embodiments described herein and having three RF electrodes and respective gas supply devices;
Figure 7 is a perspective illustration of a plasma deposition source, viewed from a substrate side, according to embodiments described herein; and
Figure 8 is a flowchart illustrating a method for depositing a thin film onto a substrate according to embodiments described herein.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a plasma deposition system for depositing, from a plasma phase, thin films onto a moving substrate. The substrate may move in a substrate transport direction in a vacuum chamber where a plasma deposition source for transferring a deposition gas into a plasma phase and for depositing, from the plasma phase, a thin film onto the moving substrate is located.

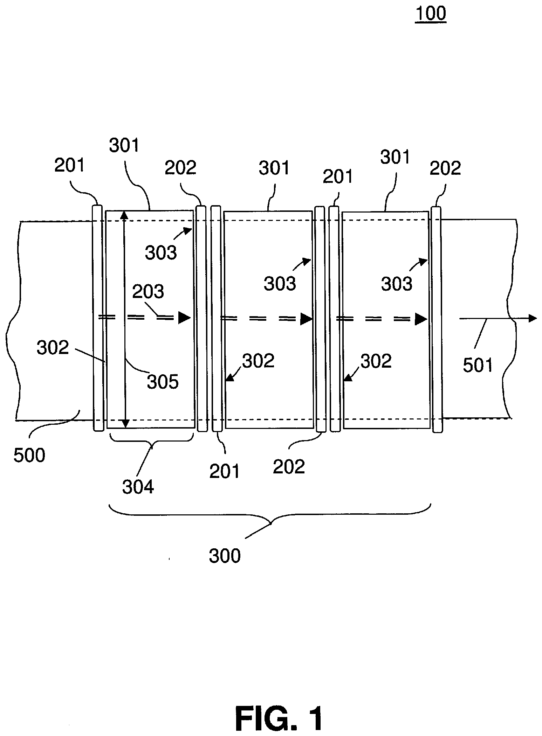

As shown in FIG. 1, and in accordance with embodiments described herein, a plasma deposition source 100 is provided as a linear PECVD (plasma-enhanced chemical vapor deposition) source having a multi-region electrode device 300 including three RF electrodes 301 arranged opposite to a moving substrate 500. In FIG. 1, the multi-region electrode device 300 is shown to be positioned over the substrate 500 moving in a substrate transport direction 501.

Generally, according to different embodiments, which can be combined with other embodiments described herein, the plasma deposition source can be adapted for depositing a thin film on a flexible substrate, e.g., a web or a foil, a glass substrate or silicon substrate. Typically, the plasma deposition source can be adapted for and can be used for depositing a thin film on a flexible substrate, e.g., to form a flexible PV module. For PV modules an efficient deposition can be provided for the opportunity to deposit different layers with significantly different film thicknesses.

The individual RF electrodes 301 each have an electrode width 304 and an electrode length 305, wherein the electrode width is measured in a direction parallel to the substrate transport direction 501 and wherein the electrode length 305 is measured in a direction perpendicular to the substrate transport direction 501 of the moving substrate 500. In a typical embodiment shown in FIG. 1, three RF electrodes 301 may have the same electrode width 304 and electrode length 305 such that an electrode area of all electrodes is the same.

The electrode area corresponds to a plasma region such that the plasma regions of the at least two electrodes 301 form a combined plasma region, which is located in one vacuum chamber. Thereby, a multi-region electrode device 300 is formed, which is located in one vacuum chamber. According to typical embodiments, one vacuum chamber is to be understood as a region not being separated by pressure apertures, valves or other elements for providing different pressures or different atmospheres in areas of a vacuum system. According to typical embodiments described herein, the pressure may be in a range from 0.01 mbar to 4.0 mbar.

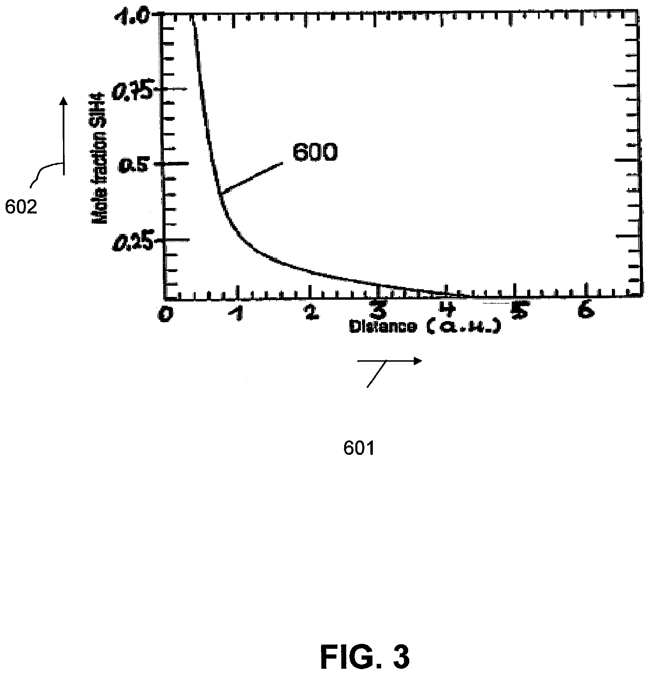

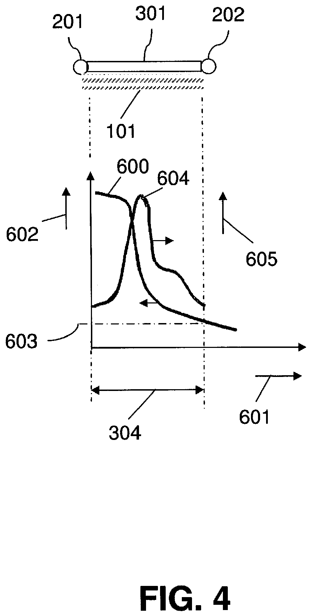

The electrode width 304 may be determined on the basis of plasma parameters such as deposition gas flow, plasma pressure, RF power and RF frequency provided at the respective RF electrode, and a deposition gas depletion profile. A determination of the electrode width 304 of the individual RF electrodes will be described herein below with respect to FIG. 3 and FIG. 4.

The electrode length 305 of an individual RF electrode 301 may be adjusted such that the electrode length 305 exceeds a lateral dimension of the moving substrate 500 perpendicular to the substrate transport direction 501. Typically, the electrode length 305 may be larger than the electrode width 304. Furthermore, the electrode width 304 may depend on an RF frequency which is used for a specific plasma deposition process.

Albeit mainly plasma deposition processes are described in the present disclosure, it is to be understood that the plasma deposition source in accordance with embodiments described herein may also be used for plasma enhanced etching processes, plasma-enhanced surface modification processes, plasma-enhanced surface activation or deactivation processes, and other plasma-enhanced processes known to the skilled person.

As shown in FIG. 1, the substrate transport direction 501 is parallel to a gas flow direction 203. At two edges of each RF electrode 301 gas inlets and gas outlets, respectively are arranged. According to different embodiments, which can be combined with other embodiments described herein, the gas inlets or gas outlets may be provided as gas lances, gas channels, gas ducts, gas passages, gas tubes, conduits, etc.. Furthermore, a gas outlet may be configured as a part of a pump which extracts gas from the plasma volume. At least one gas inlet 201 is arranged at an electrode leading edge 302 and at least one gas outlet 202 is arranged at an electrode trailing edge 303 of an individual RF electrode 301 of the multi-region electrode device 300. The electrode leading edge 302 and the electrode trailing edge 303 are defined with respect to the substrate transport direction 501.

However, according to yet further embodiments, which can be combined with other embodiments described herein, the gas inlet 201 might be disposed at the trailing edge and the gas outlet 202 might be disposed at the leading edge. Thus, albeit the embodiment shown in FIG. 1 exhibits a gas flow direction 203 parallel to the substrate transport direction 501, it is possible, according to another embodiment which may be combined with embodiments described herein, that the gas flow direction 203 is anti-parallel to the substrate transport direction by exchanging the respective positions of the gas inlet 201 and the gas outlet 202 of the respective RF electrode 301. Furthermore, it is possible to provide different gas flow directions 203 for the individual RF electrodes 301. Albeit not shown in FIG. 1, an alternating gas flow direction 203 from one RF electrode 301 to an adjacent RF electrode 301 may be provided.

It is noted here that the term "gas inlet" denotes a gas supply into a deposition region (a plasma volume 101), whereas the term "gas outlet" denotes a gas discharge or evacuation of deposition gas out of a deposition region. The gas inlet 201 and the gas outlet 202 according to a typical embodiment are arranged essentially perpendicular to the substrate transport direction 501.

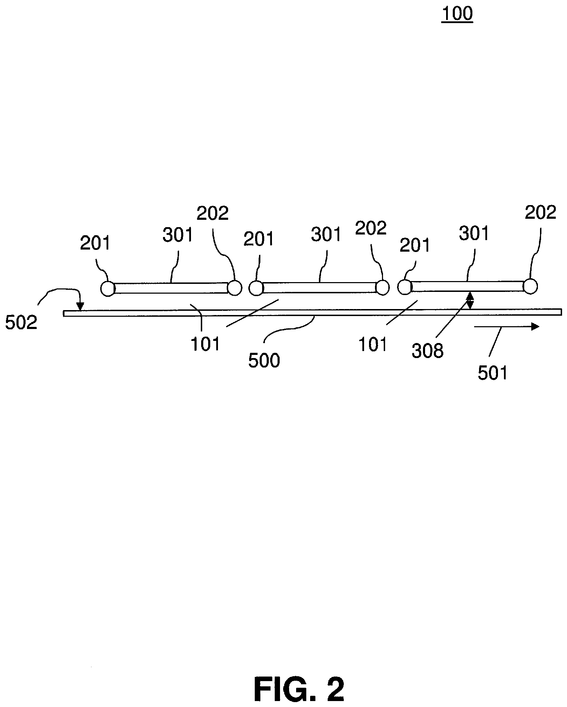

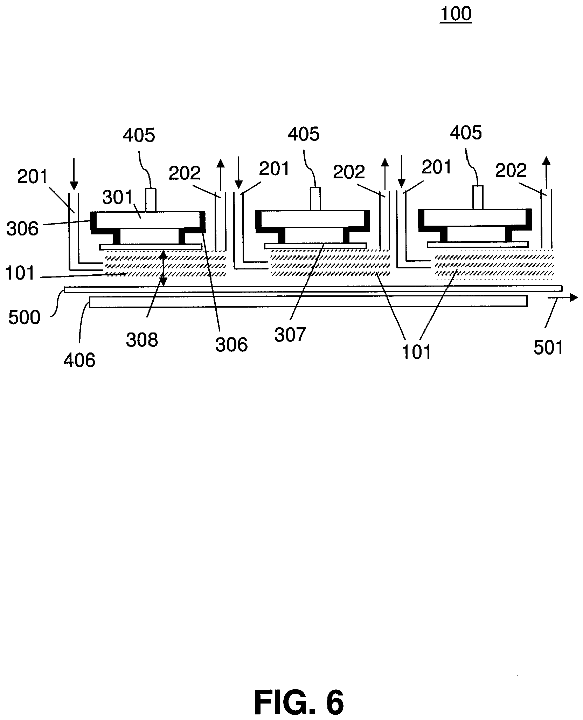

FIG. 2 is a schematic side cross-sectional view of the plasma deposition source 100 shown in FIG. 1. In operation, i.e. if RF power is applied at the individual RF electrodes and a gas flow is provided between the gas inlet 201 and the gas outlet 202, a plasma is formed in a plasma volume 101 which is located between a lower surface of an individual RF electrode 301 and a substrate surface to be coated 502, which is adjacent to a counter electrode 406 (see Fig. 6) for plasma generation. The substrate 500 to be coated is transported from left to right in the substrate transport direction 501. The individual gas inlets 201 and the individual gas outlets 202 are provided for a leading edge 302 (left edge in FIG. 2) and a trailing edge 303 (right edge in FIG. 2) for each RF electrode 301, respectively. Thus, a gas flow underneath the RF electrode is provided from the gas inlet 301 to the gas outlet 202 such that a gas flow direction 203 (see FIG. 1) is essentially parallel to the substrate transport direction 501. Furthermore, it is possible, albeit not shown in FIG. 2, that a gas flow direction is anti-parallel to the substrate transport direction 501. To provide such kind of anti-parallel gas flow at an individual RF electrode 301, the gas inlet 201 and the gas outlet 202 at the respective RF electrode 301 are exchanged with respect to each other, according to a further typical embodiment.

Accordingly, embodiments described herein are adapted for and allow for a multi.-electrode device wherein the gas flow direction with regard to the transport direction of the substrate is the same direction or an opposite direction, i.e. the gas flow direction and the transport direction are essentially parallel or essentially anti-parallel. Thereby, a multi-region electrode device can be easily up-scaled to four, five, six or even more electrodes without significantly changing the plasma process parameters in the entire, combined plasma region.

Another advantage of providing separate gas inlets 201 and gas outlets 202 for the individual RF electrodes 301, such as gas inlet channels and gas outlet channels, is the option that different deposition gases may be provided for different plasma volumes 101 provided by different RF electrodes 301. Thus, a wide variety of thin film deposition processes may be performed by using the plasma deposition source 100 having at least one RF electrode 301. During the plasma deposition process (e.g. PECVD, plasma-enhanced chemical vapor deposition), the substrate surface 502 may be provided with a thin film while the substrate 500 is moving in the substrate transport direction 501. The thin film may be provided by means of any material which can be transferred into a plasma phase by the deposition source 100. Thus, thin films and thin solid films may be deposited onto the substrate surface 502.

Albeit the cross-sectional view of FIG. 2 exhibits a planar electrode surface opposing the substrate surface 502 to be coated, the electrode cross-sectional shape is not limited to a planar shape. According to yet further embodiments, which can be combined with other embodiments described herein, other shapes, such as, but not limited to, curved cross-sectional shapes, may be provided. Advantageously, the cross-sectional shape of at least one RF electrode 301 may be adapted to a surface shape of a substrate surface 502 to be coated. The lower surface of an individual RF electrode 301 faces the substrate surface 502 to be coated such that the plasma volume 101 which is provided between an individual RF electrode 301 and the substrate 500 may be controlled.

A distance between the lower surface of the RF electrode 301 and the substrate surface 502 to be coated is referred to as an electrode-substrate gap distance 308 in FIG. 2. The plasma volume 101 is essentially defined by a (geometrical) product of the electrode length 305, the electrode width 304 (see FIG. 1) and the electrode-substrate gap distance 308.

An individual RF electrode 301 has an electrode length 305 oriented perpendicular to the substrate transport direction 501 which is at least a substrate width of the moving substrate perpendicular to the substrate transport direction 501. A normalized plasma volume may be defined by dividing the plasma volume 101 provided between the lower electrode surface and the opposite substrate surface 502, by the electrode length 305. The normalized plasma volume then is given on the basis of a deposition gas flow, a plasma pressure, an RF power applied at an individual RF electrode 301 and a RF frequency provided at the RF electrode 301. Using such a type of normalized plasma volume, an electrode width 304 of an individual RF electrode 301 may be adjusted such that an electrode width 304 parallel to the substrate transport direction 501 is given by the normalized plasma volume divided by the electrode-substrate gap distance 308 shown in FIG. 2. According to a typical embodiment the normalized plasma volume may be in the range from 5 cm² to 50 cm², a plasma density for a silicon-based PECVD process may be in a range from 10⁹ cm³ to 10¹¹ cm³, and electron temperatures may range from 1 eV to 3 eV, respectively. The flow rates of silane (SiH4) for the silicon-based PECVD process are in a range from 100 sccm to 2200 sccm.

Deposition gas which is introduced into the plasma volume 101 via the respective gas inlet 201 and which is output from the plasma volume 101 by means of the respective gas outlet 202 of an individual RF electrode 301 is subject to plasma processes which may decompose and/or change the deposition gas introduced into the plasma volume 101 on its way through the plasma volume 101 from the gas inlet 201 to the respective gas outlet 202. In case of silicon-based deposition processes, silane may be introduced into the plasma volume 101. Depletion of silane (SiH4) is an issue when the silane deposition gas is transported through the plasma volume 101. Depletion of the deposition gas may influence deposition rate, thin film composition, quality of thin films, etc.

FIG. 3 is a graph illustrating a silane depletion profile 600 as a function of a distance 601 (in arbitrary units (a.u.)). The distance 601 shown in FIG. 3 is a separation between a respective gas inlet 201 and a deposition position on the substrate surface 502 to be coated in the substrate transport direction 501, given in arbitrary units (a.u.). As shown in FIG. 3, a measure for a depletion of the deposition gas may be provided by a mole fraction of SiH₄ of the silane precursor gas (deposition gas).

It is assumed that the mole fraction of the silane deposition gas has a value of about 1.0 at a distance of 0 a.u. (an original value at the entry location into the plasma volume 101 using the gas inlet 201) and then remains at a constant level up to 0.4 a.u. Then, the silane depletion profile 600 decreases to lower values and is approximately zero at a distance of 5 a.u.away from the gas inlet 201. For silicon-based deposition processes, a mole fraction of SiH₄ may not be below a critical mole fraction as will be explained herein below with respect to FIG. 4. In order to avoid too low a mole fraction of SiH₄ 602 of the deposition gas in the plasma volume 101 defined by an individual RF electrode 301, the respective electrode width 304 parallel to the substrate transport direction 501 may be restricted to a value where the mole fraction of SiH₄ 602 is above the critical mole fraction. A silane mole fraction decreases with the distance from the gas inlet, wherein this decrease is based on at least one of the group consisting of a plasma density, a residence time, a power applied at the electrodes, a plasma pressure, an inlet silane concentration, a total flow rate, and a normalized source volume. As the depletion length shown in FIG. 3 also depends on the plasma parameters within the plasma volume 101, the electrode-substrate gap distance 308 shown in FIG. 2 may be adjusted such that a typical depletion length of the deposition gas is equal to or larger than the electrode width 304 parallel to the substrate transport direction 501.

Thereby, according to some embodiments, which can be combined with other embodiments described herein, the ratio of the electrode width and the electrode-substrate gap may be in a range from 5 to 18, and typically amounts to about 10.

For silicon-based materials which are deposited onto the substrate 500, the precursor deposition gas is silane (SiH₄). The silane precursor gas is used as a deposition gas, and once it reaches the plasma volume 101, the deposition gas is decomposed. This type of decomposition leads to a depletion of the precursor gas such that a depletion profile 600 as shown in FIG. 3 is obtained. As shown in FIG. 3, the amount of depletion of the precursor gas silane is dependent on the distance to the gas inlet 201. Thus, an electrode width 304 of an individual RF electrode 301 may be adapted such that a depletion of the precursor gas does not exceed a predetermined limit within a specified plasma volume 101. The depletion profile may depend on one or more plasma parameters such as, but not limited to, a deposition gas flow, a plasma pressure, and RF power and RF frequency provided at the respective RF electrode. Thus the normalized plasma volume which may be defined by dividing the plasma volume 101 provided between the lower electrode surface and the opposite substrate surface 502, by the electrode length 305, may be tuned to the depletion profile. Such kind of "tuning" may be provided by changing the above mentioned ratio of the electrode width and the electrode-substrate gap. For example, for a fixed RF electrode area, i.e. for fixed electrode width and fixed electrode length, the electrode-substrate gap may be adjusted such that a desired normalized plasma volume is obtained.

FIG. 4 is a more detailed view of processes occurring within the plasma volume 101. FIG. 4 illustrates a single RF electrode 301 having a gas inlet 201 at its left edge and a gas outlet 202 at its right edge. A graph below the cross-sectional view of the RF electrode 101 illustrates a mole fraction SiH₄ 602 as a function of a distance 601 from the gas inlet 201. A reference numeral 600 indicates a silane depletion profile along an electrode width 304 of the RF electrode 301. The silane depletion is shown for predetermined plasma parameters of a plasma located in a plasma volume 101 beneath the electrode surface of the RF electrode 301.

Furthermore, a SiH₃ concentration profile 604 is shown in FIG. 4. The SiH₃ concentration profile 604 is related to the silane depletion profile 600 in that a reduction of a mole fraction SiH₄ 602 results in an increase of a mole fraction SiH₃ 605. It is noted here with respect to FIG. 4 that the mole fraction SiH₄ 602 corresponds to the curve 600, wherein the mole fraction SiH₃ 605 corresponds to the curve 604. FIG. 4 relates to the silane depletion profile 600 and the SiH₃ concentration profile 604 to a geometrical dimension of the RF electrode 301, i.e. to its electrode width 304. It is assumed here that the silane depletion may not exceed a critical mole fraction 603 which is indicated by a horizontal (broken) line in FIG. 4. A depletion which is less than that indicated in FIG. 4 may be tolerable, i.e. a mole fraction of SiH₄ which is above the critical mole fraction value 603 is acceptable for a plasma located in the plasma volume 101 such that a desired thin film with respect to its composition, quality, etc. may be obtained. Another issue is the formation of reaction products such as silane dusts which increase with increasing silane depletion.

For typical plasma conditions, it has been found that an electrode width 304 which is in a range from 10 cm to 18 cm can be used for some embodiments described herein. A more typical range for the electrode width 304 may be from 12 cm to 17 cm, e.g. an electrode width 304 of 15 cm may be provided. Typical plasma parameters for electrodes having an electrode width 304 in a range from 10 cm to 18 cm include a deposition gas flow (silane gas flow) of 70 sccm up to 2200 sccm, e.g., 100 sccm, such that a particle residence time in a range from 0.01 s to 1 s is achieved. According to another typical embodiment the electrode width 304 of the RF electrode 301 is adjusted such that a particle residence time (i.e. a time a plasma particle (e.g. atom, molecule, ion) stays in the plasma) of about 0.4 s is provided. According to a typical embodiment the plasma density for a silicon-based PECVD process may be in a range from 10⁹ cm³ to 10¹¹ cm³, and electron temperatures may range from 1 eV to 3 eV, respectively. It is noted here that the depletion profile and the depletion length, respectively, is related to the particle residence time, via the above mentioned plasma parameters.

Furthermore, it is possible, albeit not explicitly shown in the drawings, to provide a mixture of silane and hydrogen (S1H₄/H₂ mixture) as a deposition gas which may be transferred into a plasma phase within the plasma volume 101. A silane-hydrogen ratio may be tuned such that a depletion length variation (see FIG. 3) may be provided. An electrode width 304 of an individual RF electrode 301 may thus be tuned for a desired depletion length. Thereby, according to yet further embodiments, the silicon layer could be deposited to be amorphous or micro-crystalline/nano-crystalline depending on the SiH₄/H₂ mixture. Typically, the SiH4/H2 mixture includes significantly more H₂ for the deposition of crystalline silicon.

The critical mole fraction shown in FIG. 4 may be determined on the basis of a typical value of the silane depletion profile 600, e.g. the critical mole fraction may be determined to be 1/10 of a maximum mole fraction. Thus, if the maximum mole fraction of silane for example is 1 in relative units (see FIG. 3), the critical mole fraction 603 may amount to approximately 0.1 such that an electrode length (distance in a.u.) amounts to approximately 3 a.u.

The electrode width 304 of an individual RF electrode 301 may be tuned to span a precursor depletion length. An overall electrode area may be adjusted by providing at least two RF electrodes 301 arranged in-line in the substrate transport direction 501. A tuning of the electrode width 304 which respect to the depletion length of the precursor gas has several advantages. Firstly, an effective deposition rate may be increased, and secondly, a level of silane dust formation may be decreased. A reduced level of silane dust formation may result in an increased source uptime. A tuning of the electrode width 304, with respect to the depletion length, may include designing an electrode width 304 of the RF electrode 301 parallel to the substrate transport direction 501 such that the electrode width 304 is less than a critical depletion length of the depletion profile of the deposition gas, the critical depletion length being defined at a point at which the deposition gas mole fraction has dropped to about 10% of the maximum mole fraction, as indicated above.

Furthermore, an electrode width 304 of an individual RF electrode 301 may be provided by defining a normalized plasma volume. The normalized plasma volume is provided by the plasma volume defined between the electrode surface and the opposite substrate position. The normalized plasma volume is then obtained by the plasma volume 101 divided by the electrode length 305 perpendicular to the substrate transport direction 105. Depending on desired plasma parameters, the electrode-substrate gap distance 308 (FIG. 2) has a specific value resulting from a dependence of the normalized plasma volume from a deposition gas flow, a plasma pressure, a RF power provided at the RF electrode 301 and an RF frequency provided at the RF electrode 301. The normalized plasma volume then is defined by the (geometrical) product of the electrode-substrate gap distance 308 and the electrode width 304. As the electrode-substrate gap distance 308 has a specific value depending on the plasma parameters and the depletion profile, the electrode width 304 may be determined on the basis of the normalized plasma volume, divided by the electrode-substrate gap distance 308.

As described above, an electrode width 304 of an individual RF electrode 301 may be determined on the basis of the silane depletion profile 600, as the depletion profile itself depends on the plasma parameter. A plasma volume can be defined being a volume 101 between the electrode surface and the opposite substrate surface. As the electrode length 305 is given by a substrate width perpendicular to the substrate transport direction 501, a normalized plasma volume may be defined which in turn depends on the electrode-substrate gap distance 308 and the electrode width 304. For specific plasma parameters, and thus for a specific depletion length, a predetermined electrode-substrate gap distance 308 is provided such that the normalized plasma volume divided by the predetermined electrode-substrate gap distance 308 gives a measure for the electrode width 304. Using this electrode width 304 for the at least one RF-electrode 301, the deposition rate may be increased wherein a silane dust formation may be reduced.

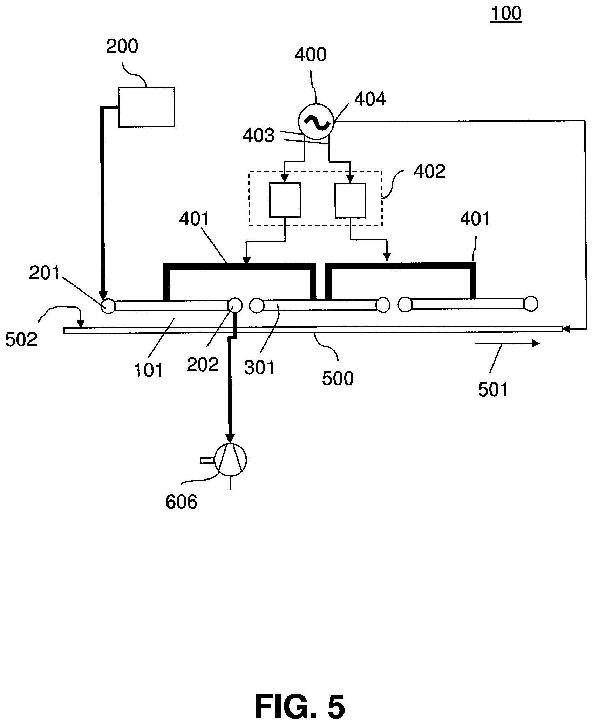

FIG. 5 is a cross-sectional side view of the plasma deposition source 100 having three RF electrodes 301, according to further embodiments. Two adjacent RF electrodes 301 are connected by a connector 401, e.g. a power bracket, to each other such that adjacent RF electrodes 301 may be driven in phase if connected to an RF generator 400. The RF generator 400 provides an RF power output between a first generator pole 403 and a second generator pole 404. Typically, the second generator pole 404 is connected to ground or to a ground electrode.

In the embodiment shown in FIG. 5 which may be combined with other embodiments described herein, the ground or counter electrode corresponds to the substrate 500. Thus, the substrate 500 is electrically connected to the second generator pole 404, e.g. by electrically conducting rollers (not shown in FIG. 5). According to yet further embodiments a ground or counter electrode might be provided in Fig. 5 below the substrate 500, i.e. such that a substrate receiving area is between the electrodes 301 and the ground or counter-electrode. A matching network 402 can be provided between the connectors 401 and the RF generator 400. The matching network 402 is provided for an impedance matching between the impedance of the RF arrangement of the RF electrodes 301 and the substrate 500, and the impedance of the RF generator 400.

The RF generator 400 may provide a fixed frequency or may provide a frequency spectrum for exciting a plasma in the plasma volume 101. The RF frequency applied at the RF electrodes or at an individual RF electrode 301 may be in a range from 10 to 100 MHz, and typically amounts to about 40.68 MHz. Other typical driving frequencies are 13.56 MHz and 94.92 MHz. The plasma parameters provided in the plasma volume 101 such as plasma density, plasma pressure, plasma composition, decomposition of precursor gas, etc. may depend on the RF frequency, the electrode width 304 and the electrode-substrate gap distance 308. The RF generator 400 may be operated with a constant RF power density or the RF power density may be varied on the basis of the requirements for the deposition plasma and its parameters.

The connectors 401 may be provided as power brackets for transferring the RF power density from the RF generator 400 via the matching network 402 to the connector 401. Furthermore, the RF generator 400 may provide frequencies depending on the electrode dimensions.

According to some embodiments, which can be combined with other embodiments described herein, the plasma deposition source 100 may be operated symmetrically, i.e. with the RF electrodes 301 connected in parallel by the connectors (power brackets) 401, from a single RF generator 400. Furthermore, the plasma deposition source 100 may alternatively be operated in a push-pull manner such that adjacent RF electrodes 301 are driven such that a phase difference of typically 180 degrees is provided between the adjacent RF electrodes 301.

The RF electrodes 301 may be connected to each other by the connectors 401 and may be connected directly to the RF generator 400 by a further connection device. Furthermore, in accordance with some embodiments which may be combined with other embodiments described herein, the connector 401 may be used to connect each RF electrode 301 individually to the RF generator 400. Thus, at least one connector 401 is provided for electrically connecting the RF electrodes 301. Furthermore, according to yet another embodiment, which may be combined with other embodiments described herein, at least two connectors 401 may be provided for connecting the RF electrodes 301 to each other, wherein the at least two connectors 401 are arranged along the electrode length 305 being perpendicular to the substrate transport direction 501. Providing at least two connectors 401 along the length 305 of the RF electrode 301 may result in a more uniform plasma distribution in the plasma volume 101 along the length 305 of the RF electrode 301 perpendicular to the substrate transport direction 501.

As shown in FIG. 5, a gas supply device 200 is provided for supplying deposition gas such as silane to the gas inlet 201. Furthermore, a vacuum pump 606 is provided which is adapted for receiving gas output via the gas outlet 202. Albeit only the gas inlet and outlet lances 201, 202 of one RF electrode 301 are shown to be connected to a gas supply device 200 and the vacuum pump 606, all gas inlets 201 may be connected to the same or different gas supply devices 200. Additionally, all gas outlets 202 may be connected to the same or different vacuum pumps 606. Furthermore, in accordance with yet another embodiment which can be combined with other embodiments described herein, a deposition gas flow across an RF electrode 301 from the gas inlet 201 to a gas outlet 202 may be controlled separately for each RF electrode 301.

The operation of the gas supply device 200 in combination with the vacuum pump 606 may result in a typical pressure within the vacuum chamber which is in a range from 0.01 mbar to 10 mbar, typically is in a range from 0.01 mbar to 4.0 mbar, and more typically amounts to about 0.05 mbar. It is noted here that the pressure within the vacuum chamber may influence other plasma parameters such that an electrode-substrate gap distance 308 (see FIG. 2) may be changed in order to maintain a desired plasma deposition operation. A modification of the electrode-substrate gap distance 308, in turn, may influence e.g. the plasma volume 101 and the normalized plasma volume.

Furthermore, a variety of deposition gases may be provided for each plasma volume 101 beneath an RF electrode 301. Thus, different deposition gases can be provided for different RF electrodes 301 such that complex deposition layer structures can be provided at the substrate surface 502.

FIG. 6 is a detailed cross-sectional side view of a plasma deposition source 100 including three locally separated RF electrodes 301. Each RF electrode 301 has an RF input 405 for inputting RF power from an RF generator 400 (see FIG. 5). Furthermore, each RF electrode 301 includes an electrode isolation 306 for isolating the RF electrode 301 with respect to the environment. For example, in addition to isolating the RF electrodes with respect to the environment the two or more of the electrodes 301 can be connected to each other, e.g. with a connector, e.g. a power bracket. In addition to that, an electrode surface coating 307 protects each RF electrode 301 from plasma exposure.

According to some embodiments, which can be combined with other embodiments described herein, the surface coating of the electrodes can be provided as covers, for example made of glass or quartz. Typically, the covers can be removable, e.g. by clamping the covers on the electrodes. This allows for easy and fast replacement of the covers during maintenance of the thin film deposition system. Typically, a cover is adapted to be removably fixed to the electrode allowing replacement of low cost design covers. Furthermore, in addition to a protection of the RF electrodes, a high secondary electron emission coefficient of the electrode cover may provide a plasma stabilization at high pressures .

FIG. 6 shows an input of the deposition gas through the gas inlet 201 and an output of the deposition gas through the gas outlet 202 separately for each electrode, in more detail. The gas inlet 201 is adapted to direct the deposition gas directly into the plasma volume 101, whereas the gas outlet 202 is provided at an upper rim of the plasma volume 101. As mentioned before, the plasma volume is defined by the geometrical dimensions of the electrode and by the electrode-substrate gap distance 308, i.e. the plasma volume 101 is defined by the product of the electrode-substrate gap distance 308, the electrode width 304 and the electrode length 305 (see FIG. 1).

According to some embodiments which can be combined with other embodiments described herein, the substrate 500 to be coated is located between the respective RF electrodes 301 and a counter-electrode 406. The counter-electrode 406 may be grounded, wherein the RF inputs 405 of the individual RF electrodes 301 are connected to the other pole of the RF generator 400 (see FIG. 5). The electrode arrangement shown in FIG. 6 has the advantage that the substrate 500 to be coated, which moves in the substrate transport direction 501, is not galvanically contacted for plasma generation purposes. Especially in the case of moving substrates 500, the arrangement shown in FIG. 6 may be used for deposition processes.

It is noted here, albeit not shown in the drawings, that the plasma deposition source 100 may be installed within a vacuum chamber in order to provide plasma deposition processes at reduced ambient pressure.

Albeit deposition processes are described with respect to the present disclosure, it is noted here that the plasma deposition source 100 according to at least one of the embodiments described herein may be used for other plasma processes, such as, but not limited to, plasma etching processes, surface modification processes, plasma-enhanced surface activation, plasma-enhanced surface deactivation, etc..

According to yet another embodiment, which is not shown in the drawings, the electrodes may have a curved cross-sectional shape or may be arranged such that they rotate during a plasma deposition process. The RF electrodes 301 may be driven in phase or may be driven out of phase. Each RF electrode 301, with its respective gas inlet and gas outlets 201, 202 within the multi-region electrode device 300, may be operated separately. Thus, it is possible to provide different gases, different RF powers, different RF frequencies at the individual regions defined by a RF electrode 301. Thus, at least one different deposition gas may be fed into the plasma volume 101 provided by at least one RF electrode 301 with respect to the remaining RF electrodes 301.

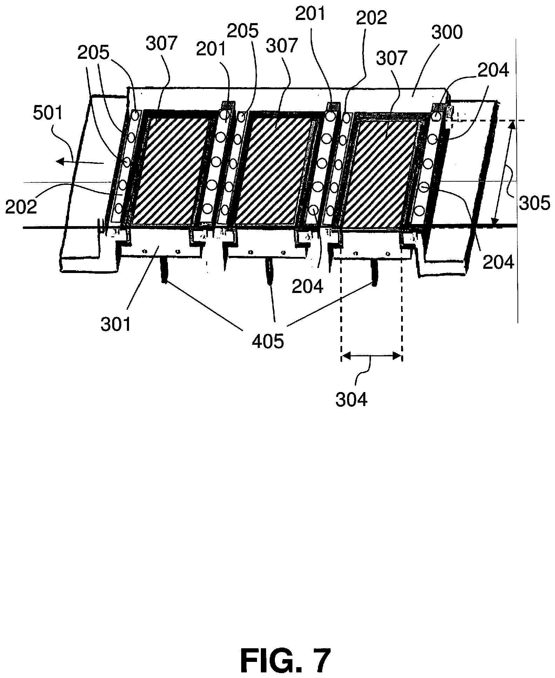

FIG. 7 is a perspective view of the plasma deposition source 100, viewed at an observation angle from the bottom side where the substrate (not shown) is transported, in a substrate transport direction 501, past the RF electrodes 301. The RF electrodes 301 each have an electrode surface coating 307 for protecting the respective RF electrodes 301 from plasma exposure. The RF electrodes 301 each have gas lances at their edges perpendicular to the substrate transport direction 501, i.e. a respective gas inlet 201 and a respective gas outlet 202. The gas inlet 201 may have gas inlet openings 204 provided along the length of the gas inlet 201. Each RF electrode 301 of the multi-region electrode device 300 may be provided with RF power separately via RF inputs 405.

According to some embodiments, which can be combined with other embodiments described herein, the gas outlet 202 and, particularly the gas inlet 201, can be configurable or exchangeable. Thereby, for example, a gas distribution bar with opening 204 can be provided such that the gas distribution in the plasma region can be controlled. According to typical embodiments, the gas distribution bar can have a symmetrical design with respect to the center line of the deposition source parallel to the substrate transport direction 501. For example, the edge regions of the gas distribution bars with regard to the length directions of the electrodes, might be provided with additional or larger openings 204 such that a loss of precursor gases at the edge of the electrode can be compensated for. Furthermore, according to yet another typical embodiment, the edge regions of the gas distribution bars with regard to the length directions of the electrodes, might be provided with fewer or smaller openings 204 in order to reduce a buildup of deposition precursors and/or in order to further smooth the deposition profile. In addition to that, gas inlet openings 204 and/or gas outlet openings 205 may be provided in the form of slots. The respective slot may exhibit a varying slot width along the length of the slot, e.g. a larger or smaller slot width at the edge regions of the gas distribution bars.

Similarly, according to some embodiments, which can be combined with other embodiments described herein, a gas pumping channel with opening 204 or a slit can be provided such that the evacuation from the plasma region can be controlled or adapted for uniform plasma behavior, i.e. uniform deposition over the substrate along the substrate direction perpendicular to the substrate moving direction. Thereby, according to typical embodiments, the gas pumping bar or gas pumping channel can have a symmetrical design with respect to the center line of the deposition source parallel to the substrate moving direction. Generally, the gas pumping channel can be configurable or exchangeable such that the existing differences in the length of the pumping channels are compensated for and a uniform flow resistance along the length of the gas outlet is provided.

The multi-region electrode device 300 may be operated at driving RF frequencies in a range from 10 to 100 MHz, wherein typical frequencies are about 13.56 MHz to 94.92 MHz. The chosen driving RF frequency inter alia depends on the electrode dimensions. The multi-region electrode device 300 may be scaled up in dimension in order to provide a plasma enhanced-deposition of thin films onto larger substrates 500. In the case of an upscaling, a driving RF frequency may change in order to avoid a standing wave effect, which primarily affects the coating uniformity. Connectors 401 (power brackets), which have been shown in FIG. 5 and described herein above, may be provided along the electrode length 305 in order to provide a uniform excitation of the plasma in the plasma volume. At least two connectors 401 may be arranged along the electrode length 305 which is perpendicular to the substrate transport direction 501.

The electrode length 305 perpendicular to the substrate transport direction 501 may be in a range from 80 cm to 200 cm and typically in a range from 120 cm to 180 cm. According to another typical embodiment the electrode length 305 amounts to about 150 cm.

The at least two connectors 401 provided along the electrode length 305 of an individual RF electrode 301 and which can be used for connecting the RF electrodes 301 to each other may be used to adjust an electric field uniformity and thus a plasma uniformity in the plasma volume (not shown in FIG. 7). Furthermore, by connecting the individual RF electrodes 301 separately to at lest one RF generator 400, a push-pull mode between two adjacent RF electrodes may be provided.

As shown in FIG. 7, a gas flow direction, i.e. a gas flow from the gas inlet 201 to the gas outlet 202 across a RF electrode 301, is parallel to the substrate transport direction 501. Furthermore, it is possible that gas flow directions across two adj acent RF electrodes are aligned such that they are opposite to each other. Furthermore, according to yet another embodiment which can be combined with other embodiments described herein, a gas flow of the deposition gas may be adjusted such that the gas flow directions across all RF electrodes 301 are anti-parallel to the substrate transport direction 501.

According to some of the embodiments described above, an electrode width 304 of the RF electrode 301 may be adjusted in relation to a depletion profile of the precursor gas such that a silane dust formation is reduced. Furthermore, deposition rates may be increased if the electrode width 304 is tuned with respect to the plasma parameters of the plasma provided in the plasma volume 101 and a depletion profile of the precursor gas. A further advantage is a more effective utilization of the deposition gas.

Thus, advantageously, a quality of thin films deposited onto the substrate surface 502 of the moving substrate 500 is improved. The plasma deposition source 100 including the multi-region electrode device 300 may be used for deposition processes, as described herein above. Furthermore, according to yet further embodiments, the multi-region electrode device 300 may be designed for a use for etching and other surface modification processes such as, but not limited to, surface activation, surface passivation, etc.

The deposition rate may be increased with a degree of activation of gas-phase precursors in a direct vicinity of the substrate surface 502 of the moving substrate 500. These gas-phase precursors are controlled by a RF power density, the electrode-surface gap distance 308, a process gas flow 203 and a process gas composition. A formation of silane dust may be reduced on the basis of an adjustment of the electrode width 304 with respect to the depletion length of the precursor gas silane. A tuning of the electrode width 304 may thus effectively be provided to match a desired precursor depletion length profile.

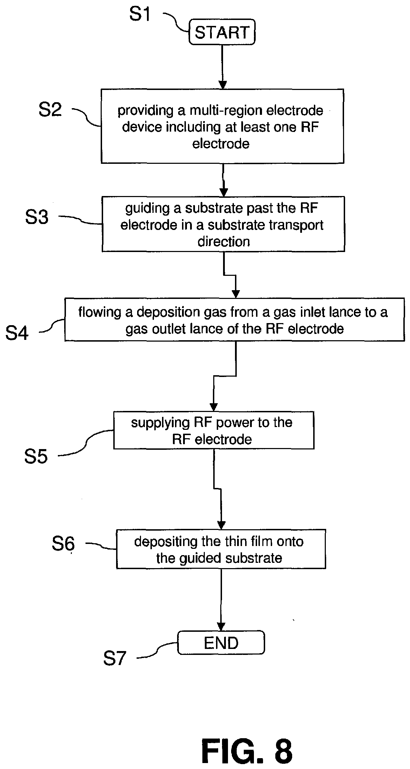

FIG. 8 is a flowchart illustrating a method for depositing a thin film onto a substrate. The method includes steps S1 to S7. The procedure starts at a step S1 and proceeds to a step S2 where a multi-region electrode device including at least two locally separated RF electrodes is provided. At a step S3, a substrate is guided past the RF electrodes in a substrate transport direction. Each of the at least two locally separated RF electrodes has a separate gas inlet and a separate gas outlet arranged at edges of the RF electrode which are perpendicular to the substrate transport direction. In step S4, a deposition gas is guided from a respective gas inlet to a respective gas outlet of an individual RF electrode. At step S5, RF power is supplied to the at least two RF electrodes. Thereby, in step S6, a thin film is deposited onto the guided substrate, which moves in the substrate transport direction. The procedure is ended at a step S7.

In light of the above, a plurality of embodiments have been described. For example, according to one embodiment, a plasma deposition source adapted for transferring a deposition gas into a plasma phase and for depositing, from the plasma phase, a thin film onto a substrate moving in a substrate transport direction in a vacuum chamber is provided. The plasma deposition source includes a multi-region electrode device adapted to be positioned in the vacuum chamber and including at least one RF electrode arranged opposite to the moving substrate and an RF power generator adapted for supplying RF power to the RF electrode. The RF electrode has at least one gas inlet arranged at one edge of the electrode and at least one gas outlet arranged at the opposed edge of the RF electrode. According to an optional modification thereof, an electrode width of the RF electrode parallel to the substrate transport direction is less than the critical depletion length of the deposition gas, the critical depletion length being defined at a point at which the deposition gas mole fraction has dropped to a value of about 10% of its original value. According to yet further additional or alternative modifications, the RF electrode defines a plasma volume between an electrode surface and an opposite substrate position within the vacuum chamber. According to yet further embodiments, which can be combined with any of the other embodiments and modifications above, a normalized plasma volume is provided by the plasma volume defined between the electrode surface and the opposite substrate position, divided by an electrode length, wherein the normalized plasma volume is provided on the basis of a deposition gas flow, a plasma pressure, the RF power and an RF frequency provided at the RF electrode. According to yet further additional or alternative modifications, a gas supply device is provided which is adapted for supplying the deposition gas to the plasma volume. According to yet further embodiments, which can be combined with any of the other embodiments and modifications above, the at least one gas inlet is arranged at a leading edge of the RF electrode, and the at least one gas outlet is arranged at a trailing edge of the RF electrode, with respect to the substrate transport direction. According to yet another modification, the gas inlet and the gas outlet are arranged essentially perpendicular to the substrate transport direction. According to yet further embodiments, which can be combined with any of the other embodiments and modifications above, the plasma deposition source further includes at least one connector adapted for electrically connecting RF electrodes to each other. According to yet another modification, the plasma deposition source includes at least two connectors adapted for connecting RF electrodes to each other, wherein the at least two connectors are arranged along the electrode length being perpendicular to the substrate transport direction. At least two electrodes may be connected to a common generator pole. According to an optional modification, a matching network is provided for connecting the RF power generator to the multi-region electrode device. Furthermore, a counter-electrode may be arranged at a side of the moving substrate opposite to the at least RF electrode. According to a further modification, a RF frequency applied at the RF electrode is in a range from 10 to 100 MHz, and typically amounts to about 40.68 MHz. According to yet a further modification, the electrode width is in a range from 10 cm to 18 cm, typically in a range from 12 cm to 17 cm, and more typically amounts to about 15 cm. According to yet further embodiments, which can be combined with any of the other embodiments and modifications above, the electrode length perpendicular to the substrate transport direction is in a range from 80 cm to 200 cm, typically in the range from 120 cm to 180 cm, and more typically amounts to about 150 cm.

According to another embodiment, a method for depositing a thin film onto a substrate is provided. The method includes providing a multi-region electrode device including at least one RF electrode; guiding a substrate past the RF electrode in a substrate transport direction; flowing a deposition gas from a gas inlet to a gas outlet of RF electrode; supplying RF power to the RF electrode; and depositing the thin film onto the guide substrate. According to an optional modification thereof, the method further may include controlling the deposition gas flow across the RF electrode from the gas inlet to the gas outlet separately for each RF electrode. According to yet further embodiments, which can be combined with the above modification or the above embodiment, the at least two RF electrodes are driven in phase. According to yet another modification, two adjacent electrodes are driven by a predetermined phase difference between each other. According to yet another embodiment, an electric field uniformity is adjusted by means of at least two connectors which are provided for connecting the RF electrodes to each other, along an electrode length being perpendicular to the substrate transport direction. According to yet another modification which may be combined with other modifications described above, an electrode-substrate gas distance is adjusted such that a depletion length of the deposition gas is equal to or larger than an electrode width parallel to the substrate transport direction. According to yet a further modification, at least one different deposition gas is fed into the plasma volume provided by at least one RF electrode with respect to the remaining RF electrodes. Furthermore, according to yet another embodiment, the at least two RF electrodes are driven in a push-pull mode. An electrode width of the RF electrode is adjusted, according to yet another embodiment, such that a particle residence time is in a range from 0.01 s to 1 s, and typically amounts to about 0.4 s. According to yet further embodiments, which may be combined with embodiments and modifications described herein above, a gas flow of the deposition gas is adjusted such that gas flow directions across two adjacent RF electrodes are opposite to each other. Furthermore, a gas flow of the deposition gas may be adjusted such that the gas flow directions across all RF electrodes are parallel or anti-parallel to the substrate transport direction.

While the foregoing is directed to embodiments of the invention, other and further embodiments of the invention may be devised without departing from the basic scope thereof, and the scope thereof is determined by the claims that follow.

## Claims

1. A plasma deposition source (100) adapted for transferring a deposition gas into a plasma phase and for depositing, from the plasma phase, a thin film onto a substrate (500) moving in a substrate transport direction (501) in a vacuum chamber, the plasma deposition source (100) comprising:
an electrode device (300) adapted to be disposed in the vacuum chamber and comprising at least one RF electrode (301), the electrode (301) having an electrode width (304) parallel to and an electrode length (305) perpendicular to the substrate transport direction (501), and being arranged opposite to the moving substrate (500), and
wherein a normalized plasma volume is provided by a plasma volume (101) defined between an electrode surface and an opposing substrate position, divided by the electrode length (305); a RF power generator adapted for supplying RF power to the RF electrode (301),
wherein the RF electrode (301) has at least one gas inlet (201) arranged at one edge of the RF electrode (301) and at least one gas outlet (202) arranged at the opposing edge of the RF electrode (301), **characterized in that** the electrode width (304) of the RF electrode (301) parallel to the substrate transport direction (501) is less than a critical depletion length of a depletion profile (600) of the deposition gas, and/or wherein an electrode-substrate gap distance (308) is such that the critical depletion length of the deposition gas is equal to or larger than an electrode width (304) of the RF electrode (301) parallel to the substrate transport direction (501), wherein
the critical depletion length is defined at about 10% of a maximum mole fraction of the deposition gas.

2. The plasma deposition source (100) in accordance with claim 1, wherein the RF electrode (301) defines a plasma volume (101) in a range from 1200 cm³ to 7200 cm³ between an electrode surface and an opposite substrate position, within the vacuum chamber.

3. The plasma deposition source (100) in accordance with any one of the preceding claims, wherein the at least one gas inlet (201) is arranged at a leading edge of the RF electrode (301), and the at least one gas outlet (202) is arranged at a trailing edge of the RF electrode (301), with respect to the substrate transport direction (501).

4. The plasma deposition source (100) in accordance with any one of the preceding claims, further comprising at least one connector (401) adapted for electrically connecting at least two RF electrodes (301) to each other.

5. The plasma deposition source (100) in accordance with any one of the preceding claims, further comprising at least two connectors (401) adapted for connecting at least two RF electrodes (301) to each other, wherein the at least two connectors (401) are arranged along the electrode length (305) being perpendicular to the substrate transport direction (501).

6. The plasma deposition source (100) in accordance with any one of the preceding claims, wherein the at least two electrodes (301) are connected to a common generator pole (403).

7. The plasma deposition source (100) in accordance with any one of the preceding claims, wherein the electrode width (304) parallel to the substrate transport direction (501) is in a range from 10 cm to 18 cm, typically in a range from 12 cm to 17 cm, and more typically amounts to about 15 cm.

8. A method for depositing a thin film onto a substrate (500), the method comprising:
providing an electrode device (300) comprising at least one RF electrode (301);
guiding the substrate (500) past the RF electrode (301) in a substrate transport direction (501);
flowing a deposition gas from a gas inlet (201) to a gas outlet (202); supplying RF power to the RF electrode (301); and
depositing the thin film onto the guided substrate (500), **characterized in that** the width (304) of the RF electrode (301) parallel to the substrate transport direction (501) is less than a critical depletion length of the deposition gas, and/or wherein an electrode-substrate gap distance (308) is adjusted such that the critical depletion length of the deposition gas is equal to or larger than an electrode width (304) of the RF electrode (301) parallel to the substrate transport direction (501), wherein
the critical depletion length is defined at a point at which a deposition gas mole fraction has dropped to a value of about 10% of its original value.

9. The method in accordance with claim 8, wherein at least two RF electrodes (301) are driven in phase.

10. The method in accordance with claims 8 or 9, wherein an electric field uniformity is adjusted by means of at least two connectors (401) which are provided for connecting at least two RP electrodes (301) to each other, along an electrode length (305) being perpendicular to the substrate transport direction (501).

11. The method in accordance with any of claims 8 to 10, wherein a normalized plasma volume is provided by a plasma volume (101) defined between an electrode surface and an opposing substrate position, divided by the electrode length (305), and wherein the normalized plasma volume is tuned to a depletion length of the deposition gas.

12. The method in accordance with claim 11, wherein the normalized plasma volume is in a range between 5 cm² and 50 cm², particularly in a range between 10 cm² and 36 cm².

13. The method in accordance with any one of the preceding claims 8 to 12, wherein the electrode width (304) of the RF electrode (301) is provided such that a particle residence time is in a range from 0.01 s to 1 s, and typically about 0.4 s.

## Patentansprüche

1. Plasmaabscheidungsquelle (100), die geeignet ist, ein Abscheidungsgas in eine Plasmaphase zu übertragen und aus der Plasmaphase einen dünnen Film auf einem Substrat (500) abzuscheiden, das sich in einer Substrattransportrichtung (501) in einer Vakuumkammer bewegt, wobei die Plasmaabscheidungsquelle (100) umfasst:
eine Elektrodenvorrichtung (300), die geeignet ist, in der Vakuumkammer angeordnet zu werden und mindestens eine RF-Elektrode (301) umfasst, wobei die Elektrode (301) eine Elektrodenbreite (304) parallel zu und eine Elektrodenlänge (305) senkrecht zu der Substrattransportrichtung (501) aufweist, und gegenüber dem sich bewegenden Substrat (500) angeordnet ist, und
wobei ein normiertes Plasmavolumen durch ein Plasmavolumen (101) bereitgestellt wird, das zwischen einer Elektrodenoberfläche und einer gegenüberliegenden Substratposition definiert ist, geteilt durch die Elektrodenlänge (305); einen RF-Leistungsgenerator, der zum Liefern von RF-Leistung an die RF-Elektrode (301) geeignet ist,
wobei die RF-Elektrode (301) mindestens einen an einer Kante der RF-Elektrode (301) angeordneten Gaseinlass (201) und mindestens einen an der gegenüberliegenden Kante der RF-Elektrode (301) angeordneten Gasauslass (202) aufweist,
**dadurch gekennzeichnet, dass** die Elektrodenbreite (304) der RF-Elektrode (301) parallel zur Substrattransportrichtung (501) kleiner als eine kritische Verarmungslänge eines Verarmungsprofils (600) des Abscheidungsgases ist, und/oder wobei ein Elektroden-Substrat-Spaltabstand (308) derart ist, dass die kritische Verarmungslänge des Abscheidungsgases gleich oder größer als eine Elektrodenbreite (304) der RF-Elektrode (301) parallel zur Substrattransportrichtung (501) ist, wobei
die kritische Verarmungslänge bei etwa 10% eines maximalen Stoffmengenanteils des Abscheidungsgases definiert ist.

2. Plasmaabscheidungsquelle (100) nach Anspruch 1, wobei die RF-Elektrode (301) ein Plasmavolumen (101) in einem Bereich von 1200 cm³ bis 7200 cm³ zwischen einer Elektrodenoberfläche und einer gegenüberliegenden Substratposition innerhalb der Vakuumkammer definiert.

3. Plasmaabscheidungsquelle (100) nach einem der vorhergehenden Ansprüche, wobei der mindestens eine Gaseinlass (201) an einer Vorderkante der RF-Elektrode (301), und der mindestens eine Gasauslass (202) an einer Hinterkante der RF-Elektrode (301) bezüglich der Substrattransportrichtung (501) angeordnet ist.

4. Plasmaabscheidungsquelle (100) nach einem der vorhergehenden Ansprüche, ferner umfassend mindestens einen Verbinder (401), der geeignet ist, mindestens zwei RF-Elektroden (301) elektrisch miteinander zu verbinden.

5. Plasmaabscheidungsquelle (100) nach einem der vorhergehenden Ansprüche, ferner mit mindestens zwei Anschlüssen (401), die geeignet sind, mindestens zwei RF-Elektroden (301) miteinander zu verbinden, wobei die mindestens zwei Anschlüsse (401) entlang der Elektrodenlänge (305), welche senkrecht zur Substrattransportrichtung (501) ist, angeordnet sind.

6. Plasmaabscheidungsquelle (100) nach einem der vorhergehenden Ansprüche, wobei die mindestens zwei Elektroden (301) mit einem gemeinsamen Generatorpol (403) verbunden sind.

7. Plasmaabscheidungsquelle (100) nach einem der vorhergehenden Ansprüche, wobei die Elektrodenbreite (304) parallel zur Substrattransportrichtung (501) in einem Bereich von 10 cm bis 18 cm, typischerweise in einem Bereich von 12 cm bis 17 cm, liegt und typischerweise etwa 15 cm beträgt.

8. Verfahren zum Aufbringen einer dünnen Schicht auf ein Substrat (500), wobei das Verfahren umfasst:
Bereitstellen einer Elektrodenvorrichtung (300) mit mindestens einer RF-Elektrode (301);
Führen des Substrats (500) an der RF-Elektrode (301) vorbei in einer Substrattransportrichtung (501);
Strömen eines Abscheidegases von einem Gaseinlass (201) zu einem Gasauslass (202); Zuführen von RF-Leistung zu der RF-Elektrode (301); und
Aufbringen der Dünnschicht auf das geführte Substrat (500),
**dadurch gekennzeichnet, dass** die Breite (304) der RF-Elektrode (301) parallel zur Substrattransportrichtung (501) kleiner als eine kritische Verarmungslänge des Abscheidungsgases ist, und/oder wobei ein Elektroden-Substrat-Spaltabstand (308) so eingestellt ist, dass die kritische Verarmungslänge des Abscheidungsgases gleich oder größer als eine Elektrodenbreite (304) der RF-Elektrode (301) parallel zur Substrattransportrichtung (501) ist, wobei
die kritische Verarmungslänge an einem Punkt definiert ist, an dem ein Abscheidungsgasstoffmengenanteil auf einen Wert von etwa 10 % seines ursprünglichen Wertes gefallen ist.

9. Verfahren nach Anspruch 8, bei dem mindestens zwei RF-Elektroden (301) in Phase betrieben werden.

10. Verfahren nach Anspruch 8 oder 9, bei dem eine Gleichmäßigkeit des elektrischen Feldes mittels mindestens zweier Verbinder (401) eingestellt wird, die zum Verbinden von mindestens zwei RP-Elektroden (301) miteinander vorgesehen sind, wobei eine Elektrodenlänge (305) senkrecht zur Substrattransportrichtung (501) verläuft.

11. Verfahren nach einem der Ansprüche 8 bis 10, wobei ein normiertes Plasmavolumen durch ein zwischen einer Elektrodenoberfläche und einer gegenüberliegenden Substratposition definiertes Plasmavolumen (101), geteilt durch die Elektrodenlänge (305), bereitgestellt wird und wobei das normierte Plasmavolumen auf eine Verarmungslänge des Abscheidungsgases eingestellt wird.

12. Verfahren nach Anspruch 11, wobei das normalisierte Plasmavolumen in einem Bereich zwischen 5 cm² und 50 cm² liegt, insbesondere in einem Bereich zwischen 10 cm² und 36 cm².

13. Verfahren nach einem der vorhergehenden Ansprüche 8 bis 12, wobei die Elektrodenbreite (304) der RF-Elektrode (301) derart vorgesehen ist, dass eine Partikelverweilzeit im Bereich von 0,01 s bis 1 s und typischerweise etwa bei 0,4 s liegt.

## Revendications

1. Source de dépôt par plasma (100) adaptée pour transférer un gaz de dépôt dans une phase plasma et pour le dépôt, à partir de la phase plasma, d'un film fin sur un substrat (500) se déplaçant dans une direction de transport de substrat (501) dans une chambre sous vide, la source de dépôt par plasma (100) comprenant :
un dispositif d'électrode (300) adapté pour être placé dans la chambre sous vide et comprenant au moins une électrode RF (301), l'électrode (301) ayant une largeur d'électrode (304) parallèle à, et une longueur d'électrode (305) perpendiculaire à, la direction de transport de substrat (501), et étant agencée à l'opposé du substrat (500) mobile, et
dans laquelle un volume de plasma normalisé est fourni par un volume de plasma (101) défini entre une surface d'électrode et une position de substrat opposée, divisé par la longueur d'électrode (305) ; un générateur de puissance RF adapté pour fournir une puissance RF à l'électrode RF (301),
dans laquelle l'électrode RF (301) présente au moins une entrée de gaz (201) agencée à un bord de l'électrode RF (301) et au moins une sortie de gaz (202) agencée sur le bord opposé de l'électrode RF (301),
**caractérisée en ce que**
la largeur d'électrode (304) de l'électrode RF (301) parallèle à la direction de transport de substrat (501) est inférieure à une longueur d'épuisement critique d'un profilé d'épuisement (600) du gaz de dépôt et/ou dans laquelle une distance d'écart électrode-substrat (308) est telle que la longueur d'épuisement critique du gaz de dépôt est égale à ou plus grande qu'une largeur d'électrode (304) de l'électrode RF (301) parallèle à la direction de transport de substrat (501), dans laquelle
la longueur d'épuisement critique est définie à environ 10 % d'une fraction molaire maximale du gaz de dépôt.

2. Source de dépôt par plasma (100) selon la revendication 1, dans lequel l'électrode RF (301) définit un volume de plasma (101) dans une plage de 1200 cm³ à 7200 cm³ entre une surface d'électrode et une position de substrat opposée, à l'intérieur de la chambre sous vide.

3. Source de dépôt par plasma (100) selon l'une quelconque des revendications précédentes, dans lequel l'au moins une entrée de gaz (201) est agencée sur un bord avant de l'électrode RF (301), et l'au moins une sortie de gaz (202) est agencée sur un bord arrière de l'électrode RF (301) par rapport à la direction de transport de substrat (501).

4. Source de dépôt par plasma (100) selon l'une quelconque des revendications précédentes, comprenant en outre au moins un connecteur (401) adapté pour connecter électriquement au moins deux électrodes RF (301) l'une à l'autre.

5. Source de dépôt par plasma (100) selon l'une quelconque des revendications précédentes, comprenant en outre au moins deux connecteurs (401) adaptés pour connecter au moins deux électrodes RF (301) l'une à l'autre, dans lequel les aux moins deux connecteurs (401) sont agencés le long de la longueur d'électrode (305) étant perpendiculaire à la direction de transport de substrat (501).

6. Source de dépôt par plasma (100) selon l'une quelconque des revendications précédentes, dans lequel les au moins deux électrodes (301) sont connectées à un pôle de générateur commun (403).

7. Source de dépôt par plasma (100) selon l'une quelconque des revendications précédentes, dans lequel la largeur d'électrode (304) parallèle à la direction de transport de substrat (501) est située dans une plage de 10 cm à 18 cm, typiquement dans une plage de 12 cm à 17 cm, et plus typiquement dans des quantités d'environ 15 cm.

8. Procédé de dépôt d'un film fin sur un substrat (500), le procédé comprenant :
la fourniture d'un dispositif d'électrode (300) comprenant au moins une électrode RF (301) ;
le guidage du substrat (500) au-delà de l'électrode RF (301) dans une direction de transport de substrat (501) ;
l'écoulement d'un gaz de dépôt d'une entrée de gaz (201) vers une sortie de gaz (202) ; la fourniture de puissance de RF à l'électrode RF (301) ; et
le dépôt du film fin sur le substrat guidé (500),
**caractérisé en ce que**
la largeur (304) de l'électrode RF (301) parallèle à la direction de transport de substrat (501) est inférieure à une longueur d'épuisement critique du gaz de dépôt et/ou dans laquelle une distance d'écart électrode-substrat (308) est ajustée de telle façon que la longueur d'épuisement critique du gaz de dépôt est égale à ou plus grande qu'une largeur d'électrode (304) de l'électrode RF (301) parallèle à la direction de transport de substrat (501), dans lequel
la longueur d'épuisement critique est définie à un point auquel une fraction molaire de gaz de dépôt a chuté à une valeur d'environ 10 % de sa valeur d'origine.

9. Procédé selon la revendication 8, dans lequel au moins deux électrodes RF (301) sont conduites en phase.

10. Procédé selon les revendications 8 ou 9, dans lequel une uniformité de champ électrique est ajustée au moyen d'au moins deux connecteurs (401) qui sont prévus pour connecter au moins deux électrodes RP (301) l'une à l'autre, le long d'une longueur d'électrode (305) étant perpendiculaire à la direction de transport de substrat (501).

11. Procédé selon l'une quelconque des revendications 8 à 10, dans lequel un volume de plasma normalisé est fourni par un volume de plasma (101) défini entre une surface d'électrode et une position de substrat opposée, divisé par la longueur d'électrode (305), et dans lequel le volume de plasma normalisé est réglé sur une longueur d'épuisement du gaz de dépôt.

12. Procédé selon la revendication 11, dans lequel le volume de plasma normalisé est situé dans une plage entre 5 cm² et 50 cm², particulièrement dans une plage entre 10 cm² et 36 cm².

13. Procédé selon l'une quelconque des revendications 8 à 12, dans lequel la largeur d'électrode (304) de l'électrode RF (301) est prévue de telle façon qu'un temps de séjour de particules est situé dans une plage de 0,01 s à 1 s, et typiquement d'environ 0,4 s.
